# FASCICULE DE BREVET EUROPEEN

(11) **EP 2 806 457 B1**
(45) Date de publication et mention de la délivrance du brevet: **10.08.2022**
(21) Numéro de dépôt: 14169285.5
(22) Date de dépôt: 21.05.2014
(51) Int. Cl.: H01L 27/15, H01L 27/146, H01L 27/144

(54) **Dispositif à matrice de diodes à stabilite ameliorée**
Bauelement mit einer Matrix aus Dioden mit erhöhter Stabilität
Device comprising an array of diodes having an improved stability

(30) Priorité: 24.05.2013 FR 1301188
(43) Date de publication de la demande: 26.11.2014
(73) Titulaire: Commissariat à l'Énergie Atomique et aux Énergies Alternatives, 75015 Paris (FR)
(72) Inventeur: Mollard, Laurent, 38640 CLAIX (FR); Baier, Nicolas, 38330 SAINT NAGAIRE LES EYMES (FR); Rothman, Johan, 38000 GRENOBLE (FR)
(74) Mandataire: Ilgart, Jean-Christophe

(56) Documents cités:
- EP-A1- 1 677 353
- WO-A1-2013/079447
- US-A1- 2010 012 973
- US-A1- 2011 227 091

## Description

### DOMAINE TECHNIQUE

La présente invention est relative au domaine des diodes fabriquées sur des substrats semi-conducteurs et agencées en une matrice de diodes. L'invention a trait plus précisément aux diodes de type p/n ou n/p qui peuvent être utilisées pour des imageurs dans le visible ou dans l'infrarouge.

### ÉTAT DE LA TECHNIQUE ANTÉRIEURE

Dans de nombreuses applications, les diodes sont agencées en matrices de diodes présentes sur un substrat. Dans une matrice, les diodes sont agencées en lignes et en colonnes.

Une matrice de diode peut être utilisée pour permettre une détection d'un rayonnement électromagnétique. Il peut en effet se former des paires électrons-trous par interaction entre le rayonnement électromagnétique et le substrat. Cela permet l'apparition d'un courant proportionnel à une intensité du rayonnement incident. Chaque diode forme alors un pixel d'un imageur. Il est ainsi possible de fabriquer des imageurs dans le visible ou des imageurs infrarouge.

Inversement, une telle matrice peut être utilisée pour émettre un rayonnement électromagnétique lors du passage d'un courant dans chaque diode de façon à ce que la matrice forme une image. Chaque diode est alors un pixel d'un écran ou d'un afficheur, ou une partie d'un pixel si chaque pixel est composé de plusieurs émetteurs de rayonnement électromagnétique.

Il existe plusieurs types d'arrangements selon que les diodes sont agencées localement selon une symétrie axiale d'ordre quatre ou une symétrie axiale d'ordre six.

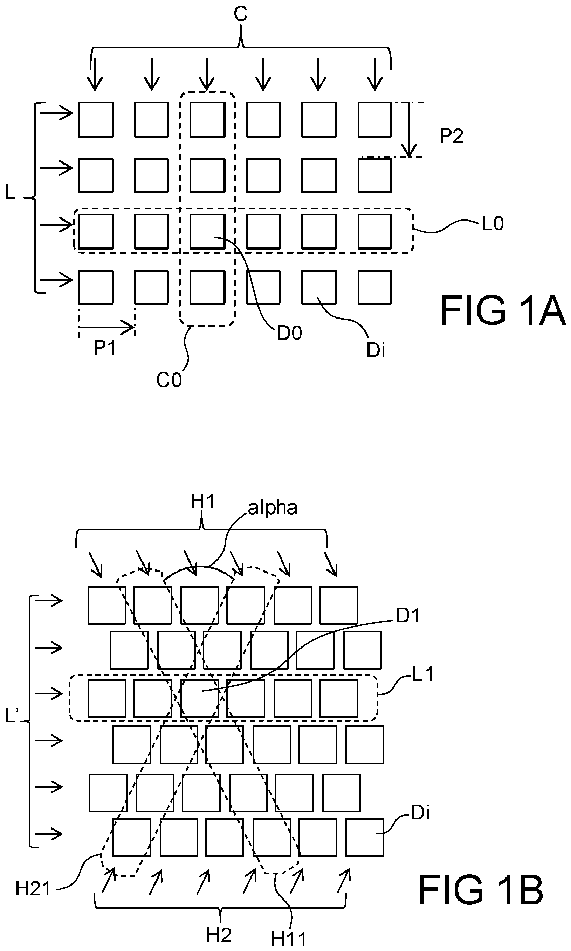

En figure 1A, il est représenté un agencement d'ordre 4 d'une matrice comportant des diodes Di. Chaque diode Di est à la croisée d'une ligne L et d'une colonne C qui forme avec la ligne un angle de 90° dans le plan de la matrice. Les diodes Di d'une ligne L sont alignées avec les diodes d'une autre ligne L voisine, formant ainsi les colonnes C. Dans la figure 1A, nous avons encadré une ligne L0 et une colonne C0, la diode nommée D0 est à la croisée de la ligne encadrée L0 et de la colonne encadrée C0. Cette configuration est classique et connue, c'est elle qui sera utilisée pour la description de l'invention dans un but de simplification. Les diodes d'une même ligne L sont séparées les unes des autres par un pas de ligne P1. Les diodes d'une même colonne C sont séparées les unes des autres par un pas de colonne P2. Ces pas sont qualifiés de pas « majoritaire » de ligne et pas majoritaire de colonne par opposition à un ou des pas « étendus » introduits plus loin. Si le pas majoritaire de ligne et le pas majoritaire de colonne sont sensiblement identiques, on peut alors parler de pas pixel en lieu et place des deux pas précités.

La figure 1B illustre un agencement de diodes en une matrice selon une symétrie axiale d'ordre 6. Dans cet exemple, les diodes D sont agencées en lignes L'. D'une ligne L' à une autre ligne voisine, les diodes Di ne sont pas alignées, mais décalées les unes par rapport aux autres. Ainsi, une diode Di d'une ligne L' est en regard avec deux diodes Di d'une ligne L' voisine. Un tel arrangement fait qu'il ne se forme pas de colonnes de diodes Di, mais une première diagonale H1 de diodes et une deuxième diagonale H2 de diodes ayant, dans le plan de la matrice, un angle donné alpha entre elles. Ici, les premières diagonales H1 sont représentées allant d'en haut à gauche vers en bas à droite de la figure 1B tandis que les deuxièmes diagonales H2 sont représentées allant d'en bas à gauche vers en haut à droite. Ainsi la diode référencée D1, est à la croisée d'une ligne L1 d'une première diagonale H11 et d'une deuxième diagonale H21 formant un angle donné alpha entre elles. L'angle donné alpha peut être sensiblement égal à 60°. Alors l'angle alpha sépare également les lignes L' des première et deuxième diagonales H1, H2.

Cet agencement de diodes ne sera pas particulièrement décrit dans la suite du document. Cependant, l'invention pourra s'y appliquer, les notions de lignes et de colonnes dans la suite de la description devant alors être remplacées par des notions de lignes, première diagonale et deuxième diagonale.

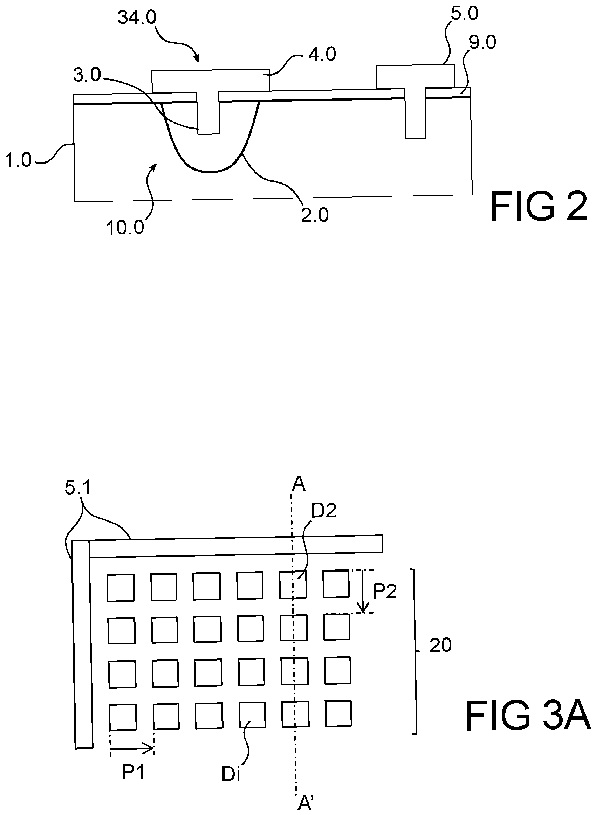

Une diode p/n, ou n/p, 10.0 telle qu'illustrée en figure 2, est présente sur un substrat 1.0 en un matériau semi-conducteur. On distingue dans le substrat 1.0 une première zone dopée, avec un premier type de dopage formée par la majorité du substrat et une deuxième zone dopée 2.0 comportant un dopant formant un deuxième type de dopage, le deuxième type de dopage étant opposé au premier type de dopage, respectivement p ou n pour une diode p/n ou une diode n/p. En général la deuxième zone dopée 2.0 est dopée avec une densité de dopage plus importante, de plusieurs ordres de grandeur, que le dopant formant le premier type de dopage dans le substrat 1.0. La deuxième zone dopée 2.0 forme une jonction p/n ou une jonction n/p avec le substrat 1.0. On considèrera qu'une diode 10.0 correspond à la jonction p/n, la deuxième zone dopée 2.0 et une zone de substrat présente autour de la deuxième zone dopée 2.0 et s'étendant sur au moins quelques nanomètres.

Au cœur de la zone dopée 2.0, un contact diode 34.0 permet de fournir ou de récupérer, tout courant circulant dans la diode 10.0. Le contact diode 34.0 comprend un pied 3.0 qui s'enfonce dans la deuxième zone dopée 2.0 et une tête 4.0 qui permet d'effectuer un contact électrique entre le pied 3.0 et une connexion électrique extérieure non représentée.

Une couche de passivation 9.0 est généralement présente entre le substrat 1.0, première et deuxième zones dopées confondues, et la tête 4.0 du contact diode 34.0. Sinon, il peut y avoir un contact électrique entre le contact diode 34, la deuxième zone dopée 2.0 et la première zone dopée du substrat 1.0. Cela conduirait à court-circuiter la diode.

Que la diode 10.0 soit utilisée en détection ou en émission, il est nécessaire qu'un courant puisse y circuler. Pour permettre une polarisation de la diode 10.0, il est nécessaire, en plus du contact diode 34.0 présent dans la zone dopée 2.0, de prévoir dans une partie du substrat extérieure à la diode 10.0, un contact substrat 5.0.

Le contact substrat 5.0 est destiné à être relié à un circuit électrique extérieur et permet d'imposer une polarisation de la diode 10.0. Le contact diode 34.0 et le contact substrat 5.0 forment ainsi deux bornes de la diode 10.0.

Lorsqu'il y a plusieurs diodes Di arrangées en une matrice, par exemple tel qu'illustré en figure 3A, le contact substrat est généralement en périphérie de la matrice 20 et mutualisé pour toutes les diodes Di de la matrice 20, on l'appellera alors contact substrat périphérique 5.1. Ce peut être par exemple une ligne conductrice bordant un, deux, trois ou quatre côtés de la matrice 20, si celle-ci définit un rectangle ou un carré dans le plan de la matrice. Ici, le contact substrat périphérique 5.1 est formé d'une ligne conductrice s'étendant sur deux côtés de la matrice 20.

Le pas majoritaire de lignes et le pas majoritaire de colonnes sont respectivement référencés P1 et P2.

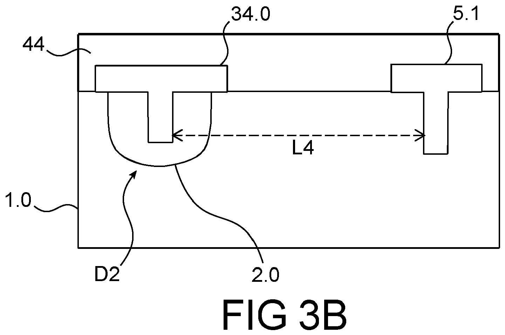

La figure 3B est une coupe selon un axe AA' de la figure 3A dirigé selon une colonne, dans lequel il n'est représenté qu'une seule diode D2 de la colonne et une partie du contact substrat périphérique 5.1. La diode D2, comporte une zone dopée 2.0 présente dans le substrat 1.0 et un contact diode 34.0 pénétrant dans la zone dopée 2.0. Le contact diode 34.0 de la diode D2 est situé à une distance donnée du contact substrat périphérique 5.1, dite distance inter-contacts de bordure L4. Le contact diode 34.0 comporte une tête en saillie par rapport à une surface principale du substrat 1.0 au dessus de la zone dopée 2.0 et éventuellement au dessus du substrat 1.0 et un pied pénétrant dans la zone dopée 2.0. De plus, une couche diélectrique 44 recouvre le substrat 1.0 et les têtes des contacts diode 34.0. Dans la suite de l'invention, par souci de simplification, la couche de passivation 9.0 est considérée comme étant présente, même si elle n'est pas représentée, sauf s'il est expressément dit le contraire.

Pour utiliser les diodes, il faut les polariser comme on l'a déjà mentionné. La polarisation du contact diode 34.0 est effectuée par un circuit de lecture (non représenté) en contact avec une métallisation présente au dessus de toutes les diodes. Une polarisation substrat est effectuée par le circuit de lecture sur le contact substrat périphérique 5.1 présent autour de la matrice.

L'interface entre le substrat 1.0 et la couche diélectrique 44 est un paramètre clef de la performance des diodes. La performance des diodes est influencée par une interaction de porteurs minoritaires avec des défauts formant des états électroniques peu profonds, qui introduisent des effets de génération/recombinaison de porteurs, ou avec des états électroniques profonds, qui introduisent des effets de charge dans la couche diélectrique.

Les états électroniques peu profonds induisant une génération/ recombinaison de porteurs présents dans une zone de charge d'espace qui s'étend autour de la jonction p/n précitée, donnent lieu à des courants de fuite.

Les états électroniques peu profonds induisant une génération/recombinaison de porteurs présents en-dehors de ladite zone de charge d'espace forment un courant d'obscurité de diffusion plus important et une réponse plus lente de la diode.

Les effets de charge introduisent une modulation de l'interaction des porteurs avec les états électroniques induisant une génération/recombinaison de porteurs. Cela conduit à une modulation de la réponse de la diode et du courant d'obscurité. Cette modulation introduit dans la matrice un bruit temporel, souvent de type 1/f. Ladite modulation introduit aussi une variation de réponse moyenne des diodes, lors de variation de température de la diode au cours de plusieurs cycles d'utilisation. Cette variation de réponse moyenne est aussi appelée bruit de cyclage.

Les effets de charge peuvent encore induire une variation de dimensions de la zone de charge d'espace, par exemple en éloignant la zone de charge d'espace de part et d'autre de la jonction p/n. Ces variations de la zone de charge d'espace peuvent donner lieu elles aussi à des bruits temporels, des bruits spatiaux et des bruits de cyclage comme décrit dans le document « 1/f noise in HgCdTe Photodiodes » par M.A. Kinch et al publié en 2008 dans le Journal of electronic Material, volume 34, numéro 6, pages 928 et suivantes.

Dans le cas de photodiodes avec un substrat à gap constant, on cherche à réduire les effets de charge à l'interface entre le substrat et la couche diélectrique en optimisant un dopage présent dans le substrat et en cherchant à obtenir une couche diélectrique de meilleure qualité.

Ces options sont cependant peu efficaces et les effets de charge à l'interface restent un problème important pour la production de photodiodes avec un bon rendement.

L'effet de charge à l'interface peut cependant être réduit par l'utilisation d'hétéro-structures, dans lesquelles, à proximité de l'interface, il est utilisé un matériau ayant un gap plus important que le restant du substrat comme décrit dans le document « MBE HgCdTe Heterostructure p-on-n Planar Infrared Photodiodes », par J.M. Arias et al en 1993 dans le Journal of electronic Material, volume 22, numéro 8, pages 1049 et suivantes. Un gap plus important permet de diminuer l'interaction des porteurs minoritaires avec l'interface, ce qui permet de réduire la génération/recombinaison de porteurs.

Ces hétéro-structures restent cependant sensibles aux variations de dimensions de la zone de charge d'espace, même si elles peuvent y être moins sensibles. De plus, en fabriquant les hétéro-structures il est généralement introduit des défauts supplémentaires à l'interface entre le matériau du substrat et le matériau à gap plus important.

US 2011/227091 A1 (voir figure 3) montre une matrice de diodes CIGS sur un substrat Si avec une zone d'isolation séparant les diodes.

US 2007/034898 A1 montre une matrice de diodes HgCdSe sur un substrat, e.g. Si ou HgCdSe. Les lignes conductrices ont une composition plus riche en Cd et donc un gap plus important.

### EXPOSÉ DE L'INVENTION

L'invention vise à stabiliser l'interface entre le substrat et la couche diélectrique en diminuant les effets de charge. Les effets de charge sont situés au niveau d'une surface principale du substrat où sont les diodes, ou au niveau d'une interface entre le substrat et une couche diélectrique recouvrant le substrat et les diodes.

L'invention vise également à diminuer l'interaction des porteurs minoritaires avec l'interface par la création d'une hétérostructure suite à une implantation ionique.

Pour y parvenir, l'invention concerne un dispositif selon la revendication 1 un substrat portant une matrice de diodes, organisées en lignes et en colonnes, et un contact substrat périphérique agencé sur au moins un côté de la matrice. Le substrat a un premier type de dopage et les diodes comportent dans le substrat, une deuxième zone dopée ayant un deuxième type de dopage, opposé au premier type. Le substrat comporte en outre plusieurs autres zones dopées, chacune formant une ligne conductrice enterrée, ces autres zones dopées ayant le premier type de dopage et une plus grande densité de dopage que le substrat, les lignes conductrices enterrées présentant un gap supérieur à celui du substrat. Les lignes conductrices enterrées sont sans liaison électrique directe avec le contact substrat périphérique, elles affleurent une surface principale du substrat du côté où sont présentes les diodes. Elles sont positionnées entre les deuxièmes zones dopées et s'étendent entre deux colonnes voisines de diodes et entre deux lignes voisines de diodes et se croisent en une intersection en formant un maillage de lignes conductrices enterrées.

De cette manière, les lignes conductrices enterrées permettent, puisqu'elles sont conductrices, un premier mode d'action pour stabiliser l'interface en diminuant les effets de charge. Les effets de charge sont situés au niveau d'une surface principale du substrat où sont les diodes, ou au niveau d'une interface entre le substrat et une couche diélectrique recouvrant le substrat et les diodes.

Le fait que les lignes conductrices enterrées aient un dopage de type même type que celui du substrat et donc opposé à celui des deuxièmes zones dopées des diodes est avantageux. Cela permet un autre mode d'action pour stabiliser ladite interface.

On rappelle que le gap d'un matériau est défini comme la différence d'énergie entre le haut de la bande de valence et le bas de la bande de conduction. Dans le cadre d'un matériau semi-conducteur dégénéré, la conductivité et la mobilité de porteurs sont d'un même ordre de grandeur que celles d'un métal.

Dans un matériau semi-conducteur dégénéré, le niveau de Fermi est situé dans une bande parmi la bande de conduction et la bande de valence et la position est fonction du dopage. Si le dopage est de type n+, le niveau de Fermi est situé dans la bande de conduction. On définit un gap effectif comme la différence d'énergie entre le niveau de Fermi situé dans la bande de conduction et l'état correspondant à la transition directe dans la bande de valence qui au premier ordre peut être assimilée au haut de la bande de valence. Dans le cadre d'un matériau dopé p+, du fait de la faible courbure de la bande de valence, on peut assimiler au premier ordre le gap et le gap effectif. Si le dopage est p+, le semi-conducteur ne sera pas dégénéré. Si le dopage est n+, le semi-conducteur sera considéré comme dégénéré pour une densité de dopage supérieure à 10¹⁷ porteurs/cm³.

Dans la présente invention le terme « gap » est employé dans sa signification habituelle exposée plus haut pour les matériaux semi-conducteurs non dégénérés et il englobe le gap effectif dans le cas d'un matériau semi-conducteur dégénéré, surtout pour les matériaux semi-conducteurs dopés n+.

Si les lignes conductrices enterrées ont un gap plus important que le matériau environnant, cela crée une barrière de potentiel au niveau des lignes conductrices enterrées.

De façon préférentielle, le substrat est en un matériau semi-conducteur, à base de HgCdTe. Par exemple, pour des diodes formées dans du Hg₁₋ₓCdₓTe, on utilisera de préférence un substrat de CdZnTe sur lequel est présente une couche superficielle de Hg₁₋ₓCdₓTe.

Le substrat est en un matériau semi-conducteur à un ou plusieurs éléments chimiques, et la ligne conductrice enterrée est composée du ou des mêmes éléments chimiques que le matériau du substrat et est préférentiellement dopée avec un élément dopant, dit dopant de ligne, de même type que celui du substrat avec un niveau de dopage supérieur à celui du substrat.

Le dopant de ligne est du même type de dopage que le substrat. Le dopant de ligne peut être présent avec une densité typiquement comprise entre 10¹⁵ et 10²⁰ at/cm³. Ceci a plusieurs avantages. Un premier avantage est de ne pas nécessiter d'étape de gravure et d'être simple à implémenter. Un deuxième avantage est qu'il est formé une barrière de potentiel au niveau de la ligne conductrice enterrée, c'est à dire au niveau de la surface précitée, fonctionnant comme encore un autre mode d'action afin de réduire les effets de charge et stabiliser ladite interface.

Dans le cadre d'un dopage n des lignes conductrices enterrées, avec une densité supérieure à 10¹⁷ at/cm³, la ligne conductrice enterrée est en matériau semi-conducteur dégénéré. C'est-à-dire que la ligne conductrice enterrée a une densité de dopants telle que le matériau semi-conducteur a une conductivité et une mobilité de porteurs intermédiaire entre le semi-conducteur et le métal. En conséquence le matériau n'est plus semi-conducteur et ne présente plus de gap mais un gap dit effectif, comme on l'a vu plus haut.

En augmentant la composition en cadmium dans un matériau en HgCdTe, on en augmente le gap.

Dans le cadre d'un dopage p des lignes conductrices enterrées, on peut obtenir des zones ayant une deuxième composition en cadmium par autodiffusion du cadmium dans la ligne conductrice enterrée, initialement à la première composition en cadmium ayant un dopage de type p+. Il est alors formé, une hétérostructure auto-positionnée en tout point comportant un dopage de type p+, en particulier dans les lignes conductrices enterrées.

Si le substrat est en un matériau à base de HgCdTe, et si les lignes conductrices enterrées ont un dopage de type « p » ou de type « p+ », le dopant de ligne est avantageusement de l'arsenic. L'arsenic, dans les matériaux en HgCdTe, est un très bon dopant de type p. A l'inverse, si les lignes conductrices enterrées ont un dopage de type « n » ou de type « n+ », le dopant de ligne est avantageusement du bore. Le bore dans les matériaux en HgCdTe peut être utilisé pour obtenir un dopage n par implantation ionique.

Les lignes conductrices enterrées sont de préférence formées de manière auto-positionnée, que ce soit dans le cadre du dopage n ou du dopage p desdites lignes conductrices enterrées.

On comprend que dans la proposition précédemment décrite, il est possible de former des matrices dans lesquelles, à la fois les zones dopées des diodes et les lignes conductrices enterrées forment une hétérostructure autopositionnée à la deuxième composition en cadmium. Pour ne pas créer de jonction de type diode entre les zones dopées des diodes et les lignes conductrices enterrées, les zones dopées des diodes et les lignes conductrices enterrées sont séparées d'au moins 0,5 micromètre. Seule l'une parmi les lignes conductrices enterrées et les zones dopées peut alors être de type p+ permettant la formation d'hétérostructures autopositionnées. Alors, de préférence, seules les lignes conductrices enterrées sont à la deuxième composition en cadmium.

De façon avantageuse, la surface principale peut être une interface entre le substrat et une couche diélectrique recouvrant les diodes et le substrat tel que pré-exposé plus haut. De cette façon, en étant proches de ladite surface ou interface, les lignes conductrices enterrées influent plus aisément pour réduire et/ou diffuser les effets de charge et stabiliser ladite surface ou interface.

Un dispositif selon l'invention comporte avantageusement une ligne conductrice enterrée entre deux colonnes voisines de diodes et/ou lignes voisines de diodes au moins toutes les k colonnes et/ou les m lignes de la matrice, k et m peuvent valoir par exemple trente, deux ou un. Il est ainsi possible de former une matrice dans laquelle toutes les diodes sont à une distance inter-contacts enterrée d'une ligne conductrice enterrée inférieure à la distance inter-contacts critique.

De façon avantageuse, chaque ligne conductrice enterrée, présente entre deux lignes voisines de diodes de longueur donnée ou entre deux colonnes voisines de diodes de longueur donnée, a une longueur supérieure ou égale à la longueur desdites lignes ou desdites colonnes. Dans le cas où la longueur est strictement supérieure, les diodes de bord sont bien stabilisées.

Les lignes conductrices enterrées ne relient pas deux branches de contact du contact substrat périphérique situées sur des côtés opposés de la matrice. Elles n'atteignent aucune des branches de contact du contact périphérique.

Les lignes conductrices enterrées ont, définies dans un plan contenant les diodes, une longueur et une largeur, la largeur est perpendiculaire à la longueur. En technologie « pas pixel 15 µm », la largeur est de préférence comprise entre environ 0,5 µm et 5 µm.

Les lignes conductrices enterrées ont une épaisseur, définie sensiblement suivant une normale à un plan contenant les diodes. En technologie « pas pixel 15 µm » l'épaisseur est comprise de préférence entre environ 0,5 µm et 2 µm.

### BRÈVE DESCRIPTION DES DESSINS

L'invention sera mieux comprise, et d'autres détails, avantages et caractéristiques de celle-ci apparaîtront à la lecture de la description suivante faite à titre d'exemple non limitatif et en référence aux dessins annexés dans lesquels :
Les figures 1A et 1B illustrent deux façons d'agencer des diodes en une matrice, soit en lignes et en colonnes, soit avec une symétrie axiale d'ordre trois ;
la figure 2 est un schéma de structure d'une diode ;
les figures 3A et 3B montrent une vue de dessus d'une matrice de diodes-et une coupe selon l'axe AA' de la matrice de diodes ;
les figures 4A et 4B illustrent respectivement en vue de dessus et en coupe une matrice de diodes selon l'invention comportant entre deux colonnes de diodes voisines une ligne conductrice enterrée ;
les figures 5, 6 et 7 illustrent trois exemples de modes de réalisation du dispositif selon l'invention comportant plusieurs lignes conductrices enterrées agencés toutes les k lignes et m colonnes de diodes, k et m ayant une même valeur dans ces exemples, et valant respectivement 30, 2 et 1.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les figures illustratives des différents modes de réalisation du dispositif selon l'invention sont données à titre d'exemple et ne sont pas limitatives.

### EXPOSÉ DÉTAILLÉ DE MODES DE RÉALISATION PARTICULIERS

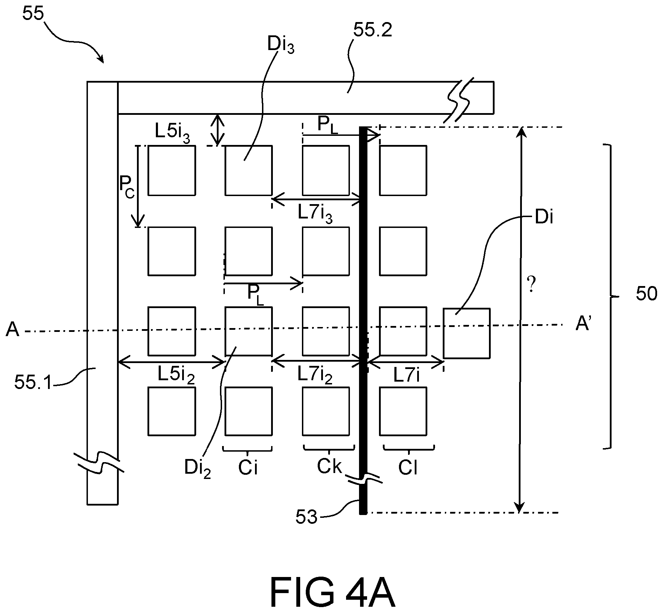

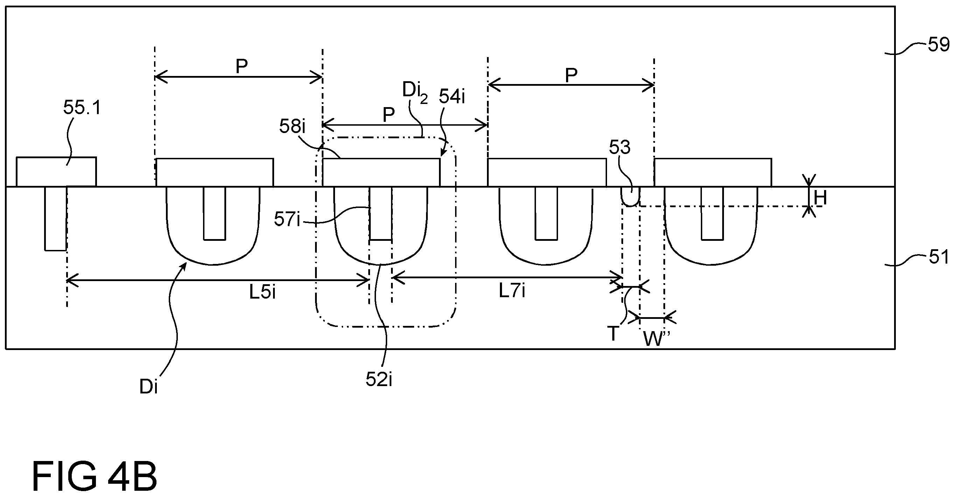

En premier lieu, l'invention concerne une matrice de diodes telle que décrite en figures 4A et 4B.

La figure 4A illustre en vue de dessus une matrice 50 de diodes Di. Celles-ci sont disposées sur un substrat représenté de façon non délimitée et sont agencées en lignes (Li) et en colonnes (Ci, Ck, Cl). Dans la figure 4A il est représenté, par esprit de simplification, dix-sept diodes Di, distribuées en quatre lignes et quatre colonnes plus une diode. Cependant, l'invention est valable pour tout arrangement et tout nombre de diodes sur plusieurs lignes et plusieurs colonnes. Chaque diode comporte en surface un contact diode permettant une prise de contact électrique entre la diode Di et un circuit électrique ou électronique non représenté. La figure 4A étant une vue de dessus de la matrice 50 de diodes, seuls les contacts diode sont représentés, car ce sont les seules parties dépassant d'une surface principale du substrat. Pour faciliter la compréhension de la figure, dans la suite de la description, pour les vues de dessus, les contacts diode représentés seront assimilés à leur diode Di respective.

Les diodes Di sont agencées périodiquement dans la matrice 50 avec un pas majoritaire de ligne P_{L} dans une même ligne et avec un pas majoritaire de colonne P_{C} dans une même colonne. Dans la suite, il sera considéré par esprit de simplification que le pas majoritaire de colonne P_{C} et le pas majoritaire de ligne P_{L} sont sensiblement égaux; leur valeur sera dénommée par l'appellation « pas pixel P ». Cependant, dans le cas où le pas majoritaire de ligne et le pas majoritaire de colonne sont différents, l'invention reste applicable, l'homme du métier sachant appliquer les enseignements de l'invention à une matrice 50 où le pas majoritaire de colonne P_{C} et le pas majoritaire de ligne P_{L} sont différents. De plus, comme annoncé précédemment, les diodes peuvent être arrangées en premières diagonales, en deuxièmes diagonales et en lignes et non uniquement en lignes et en colonnes. L'homme du métier saura aisément appliquer les enseignements de l'invention à une telle matrice.

La matrice 50 comporte en périphérie un contact substrat périphérique 55. Celui-ci est composé, dans l'exemple de cette figure, de deux branches de contact 55.1, 55.2 qui bordent la matrice 50 sur deux côtés successifs. Alternativement, le contact substrat périphérique 55 pourrait comporter une seule branche de contact, trois ou quatre branches de contact ou plus et ainsi border la matrice 50 sur autant de côtés, successifs, opposés ou autres.

Il est considéré que dans la matrice 50, au moins une diode Di est située à une distance inter-contacts de bordure de toute branche du contact substrat périphérique 55.1, 55.2 supérieure à une distance inter-contacts critique. La distance inter-contacts critique est telle qu'elle a été définie plus haut. Cela signifie qu'au moins une des diodes Di est trop éloignée de toute branche de contact 55.1, 55.2 pour que la diode ait des performances acceptables lors de son utilisation. Il s'agit par exemple d'une diode Di située dans une partie centrale de la matrice.

Pour ne pas subir les défauts provoqués dans l'art antérieur par l'utilisation de contacts substrat rapprochés, l'invention n'utilise aucun contacts substrat rapprochés.

En effet, en lieu et place des contacts substrat rapprochés, l'invention propose l'insertion, dans le substrat 51, entre au moins une première colonne Ck et une deuxième colonne Cl voisines, et/ou entre deux lignes voisines de diodes de la matrice, d'une ligne conductrice enterrée 53. Celle-ci n'a aucune extrémité en contact électrique direct avec le contact substrat périphérique 55. Cette ligne conductrice 53 n'a aucun contact électrique direct avec le contact substrat périphérique 55. Elle est, de plus, sans contact électrique direct avec une quelconque diode Di de la matrice 50, ni au niveau des contacts diodes 51, ni au niveau des zones dopées mentionnées plus haut, ou avec un autre contact électrique du dispositif.

La ligne conductrice enterrée 53 est disposée dans le substrat 51. Elle peut affleurer la surface principale du substrat 51. Cela signifie qu'une partie de la ligne conductrice enterrée 53 apparait au niveau de la surface principale du substrat 51. Ladite surface principale peut être une interface entre le substrat 51 et une couche supérieure 59, par exemple en matériau diélectrique. Cette couche diélectrique est visible sur la figure 4B. la surface principale du substrat est la surface sur laquelle les deuxièmes zones dopées émergent.

Les contacts diodes mentionnés plus haut sont positionnés au niveau de ladite surface ou interface principale.

Si la ligne enterrée conductrice 53 est positionnée entre deux colonnes voisines, respectivement deux lignes voisines, elle a une longueur λ mesurée selon une direction principale d'une colonne, respectivement d'une ligne.

Chaque diode Di de la matrice est dite à une distance inter-contacts enterrée L7i de la ligne conductrice enterrée 53. En particulier, sur la figure 4A, deux diodes quelconques Di₂, Di₃ sont référencées. Elles sont respectivement à une distance inter-contacts de bordure L5i₂, L5i₃ du contact substrat 55 et à une distance inter-contacts enterrée L7i₂, L7i₃ de la ligne conductrice enterrée 53.

La figure 4B est une coupe de la figure 4A selon un axe AA', coupant plusieurs diodes Di de la matrice 50 appartenant à une même ligne. Chaque diode Di comporte au moins une deuxième zone dopée 52i dans le substrat 51 tel que décrit plus haut en relation avec la figure 2. Par esprit de simplification, on appellera la deuxième zone dopée « zone dopée 52i» dans la suite de la description. Le substrat 51 a le premier type de dopage et les deuxièmes zones dopées 52i ont un second type de dopage apposé au premier type de dopage.

Le substrat est en un matériau semi-conducteur. Le substrat 51 peut être en HgCdTe tel le Hg₁₋ₓCdₓTe pour permettre une fabrication de diodes et en particulier de diodes à propriétés optiques.

Chaque diode Di comporte, de plus, un contact diode 54i constitué d'un pied 57i situé à l'intérieur de la zone dopée 52i et d'une tête 58i située en surface du substrat 51. La tête 58i est généralement recouverte de la couche diélectrique 59, de façon à supporter des liaisons électriques et des interconnexions non représentées reliant les diodes Di à un circuit électronique extérieur non représenté.

Sur la figure 4B est illustrée une coupe de la branche de contact 55.1 du contact substrat périphérique 55, dont au moins une partie pénètre dans le substrat 51. Il est de plus représenté des coupes de quatre diodes, dont la diode référencée Di₂, et une coupe de la ligne conductrice enterrée 53. La ligne conductrice enterrée 53 a une épaisseur H mesurée selon un axe sensiblement perpendiculaire à un plan défini par les diodes Di. La ligne conductrice enterrée 53 a de plus une largeur T mesurée de façon sensiblement perpendiculaire à l'épaisseur H et à la longueur λ.

Chaque contact diode 54i est tel qu'il existe une distance inter-contacts de bordure L5i entre le pied 57i du contact diode 54i et le contact substrat périphérique 55, ici la branche de contact 55.1. De plus, le pied 57i de chaque contact diode 54i est à une distance inter-contacts enterrée L7i de la ligne conductrice enterrée 53.

Selon l'invention, la ligne conductrice enterrée 53 est séparée au minimum par une distance minimale W" de toute zone dopée 52i des diodes Di. Une distance minimale W" trop faible pourrait conduire à former des courants de fuite entre la zone dopée 52i et la ligne conductrice enterrée 53. On ne crée pas de jonction de type diode entre elles. Cette distance W" est d'au moins 0,5 micromètre. Les lignes conductrices enterrées 53 sont situées entre les deuxièmes zones dopées 52i.

La largeur T et l'épaisseur H sont de préférence telles que de la ligne conductrice enterrée 53 ne perturbe pas la périodicité de l'agencement des diodes Di. Il est alors possible d'intercaler la ligne conductrice enterrée 53 entre deux lignes et/ou deux colonnes de la matrice, dans un espace présent de façon usuelle entre deux diodes voisines, sans modifier le pas pixel P de la matrice. La largeur T et la hauteur H de la ligne conductrice enterrée 53 sont de plus adaptées pour que la ligne conductrice enterrée 53 occupe un volume le plus important possible dans l'espace présent de façon usuelle entre deux diodes voisines sans pour autant former des courants de fuite avec les diodes. Plus la ligne conductrice enterrée 53 aura une section importante, plus elle stabilisera l'interface entre le substrat 51 et la couche diélectrique 59.

La largeur T et l'épaisseur H de la ligne conductrice enterrée 53 dépendent de la technologie utilisée pour fabriquer la matrice de diodes Di. Il va être donné en exemple de valeurs de dimensions dans le cadre d'une technologie dite « pas pixel 15 µm », dans laquelle le pas pixel ou pas majoritaire de la matrice est proche de 15 µm aussi bien pour les lignes que pour les colonnes :
La largeur T de la ligne conductrice enterrée 53 peut être comprise entre 0,5 µm et 5 µm, par exemple 1 µm ou 2 µm.

L'épaisseur H de la ligne conductrice enterrée 53 est approximativement du même ordre de grandeur que sa largeur T, par exemple comprise entre 0,5 µm et 2 µm.

De plus, dans une technologie « pas pixel 15 µm » les diodes Di peuvent avoir une tête 58i de contact diode dont la surface est de 10x10 µm², la zone dopée 52i peut avoir une surface, dans un plan parallèle à une surface principale du substrat, proche de 12x12 µm².

Si les diodes ont des dimensions différentes, soit en raison de l'utilisation d'une autre technologie de la microélectronique, soit en raison d'une application différentes pour les diodes, les dimensions de la ligne conductrice enterrée 53 sont alors adaptées.

Dans une variante préférentielle, la ligne conductrice enterrée 53 est une autre zone dopée dans le substrat. Elle est composée du ou des mêmes éléments chimiques du matériau semi-conducteur du substrat 51. Il a un dopage de même type que celui du substrat 51. Mais la ligne conductrice enterrée 53 est alors principalement différenciée du substrat 51 en ce qu'elle comporte un dopant de ligne ayant une densité de dopage importante, supérieure de plusieurs ordres de grandeur au dopage présent dans le matériau du substrat 51. La ligne conductrice enterrée 53 est alors définie comme étant dans un volume contenant le dopant de ligne, mais ce volume est dépourvu de contact électrique avec le contact substrat périphérique 51. Si une ligne conductrice enterrée 53 est présente entre deux diodes adjacentes Di, c'est la seule ligne conductrice située entre les diodes adjacente Di, aucune autre ligne conductrice étant prévue, en particulier aucune autre ligne conductrice ayant le second type de dopage.

La densité du dopant de ligne dans le matériau semi-conducteur formant la ligne conductrice enterrée est typiquement comprise entre 10¹⁵ et 10²⁰ at/cm³. A titre de comparaison, le substrat 51, hormis les zones dopées 52i des diodes Di, a une densité typiquement comprise entre 10¹⁴ et 10¹⁷ at/cm³.

Si le dopant de ligne est de type accepteur, il est obtenu un dopage de type p+. Si le dopant de ligne est de type donneur, il est obtenu un dopage de type n+.

Dans certaines situations, le dopant de ligne de type n, peut être présent avec une telle densité supérieure à 10¹⁷ at/cm³, que le matériau de la ligne conductrice enterrée 53 devient dégénéré. Cela signifie que le matériau du substrat 51, initialement semi-conducteur, acquiert, dans le volume définissant la ligne conductrice enterrée 53, un comportement intermédiaire entre celui du semi-conducteur et celui d'un métal, à cause de la présence du dopant. En pratique, le matériau de la ligne conductrice enterrée 53 a alors une conductivité et une mobilité ayant un même ordre de grandeur, mais inférieures, que celles des métaux utilisés usuellement en microélectronique.

Dans d'autres situations, la densité de dopant dans la ligne conductrice enterrée 53 est insuffisante pour avoir un matériau semi-conducteur dégénéré dans la ligne conductrice enterrée 53.

On définira dans la suite de la description une demi-longueur de la ligne conductrice enterrée 53 comme étant une distance entre la diode, la plus éloignée possible de toute partie d'un contact substrat périphérique, et ledit contact substrat, mesurée en suivant un axe sur lequel peut se trouver une ligne conductrice enterrée 53. S'il y a deux branches de contact positionnées sur des côtés opposés de la matrice, la demi-longueur sera sensiblement égale à la moitié de la distance séparant ces deux branches de contact.

Avantageusement, le matériau de la ligne conductrice enterrée 53 se différencie de la zone dopée 52i en ce que le dopant de ligne et celui de la zone dopée 52i sont de types différents. Ainsi, selon que la zone dopée 52i comporte un dopant de type p ou un dopant de type n, de façon avantageuse, la ligne conductrice enterrée 53 comportera un dopant de ligne induisant respectivement un dopage de type n ou un dopage de type p.

En particulier, si le matériau du substrat est de type HgCdTe, ou Hg₁₋ₓCdₓTe, dans le cas de diodes p/n, comportant une zone dopée 52i comportant un dopant de type p, le dopant de ligne présent dans la ligne conductrice enterrée 53 peut être de type n tel que de l'indium ou le bore. Inversement, en conservant le même matériau pour le substrat, dans le cas de diodes n/p, comportant une zone dopée 52i comportant un dopant de type n, le dopant de ligne peut être de type p tel que de l'arsenic ou autre.

L'état de la technique permet de fabriquer une matrice de diodes telle que chaque diode soit éloignée d'un contact substrat périphérique ou d'un contact substrat rapproché d'une distance inférieure à la distance inter-contacts critique.

En suivant l'enseignement de l'invention, il est possible de placer une ligne conductrice enterrée 53 entre deux lignes voisines et/ou entre deux colonnes voisines. Il est de plus possible de prévoir plusieurs lignes conductrices enterrées 53, chacune comprise entre deux lignes voisines et/ou deux colonnes voisines. S'il y a à la fois une ligne conductrice enterrée entre deux lignes voisines et une ligne conductrice enterrée entre deux colonnes voisines, les deux lignes conductrices enterrées se croisent en une intersection et forment un maillage de lignes conductrices enterrées.

Un dispositif selon l'invention peut comporter une ligne conductrice enterrée entre deux colonnes voisines de diodes et/ou lignes voisines de diodes toutes les k colonnes et/ou toutes les m lignes de la matrice, de façon périodique. Dans la suite de la description, un deuxième, un troisième et un quatrième mode de réalisation vont être présentés illustrant ceci. Dans ces différents modes de réalisation les valeurs de k et m sont égales entre elles et valent respectivement 30, 2 et 1. Il est bien entendu possible que k et m aient des valeurs différentes. C'est en particulier le cas si le pas de ligne et le pas de colonne ont des valeurs différentes.

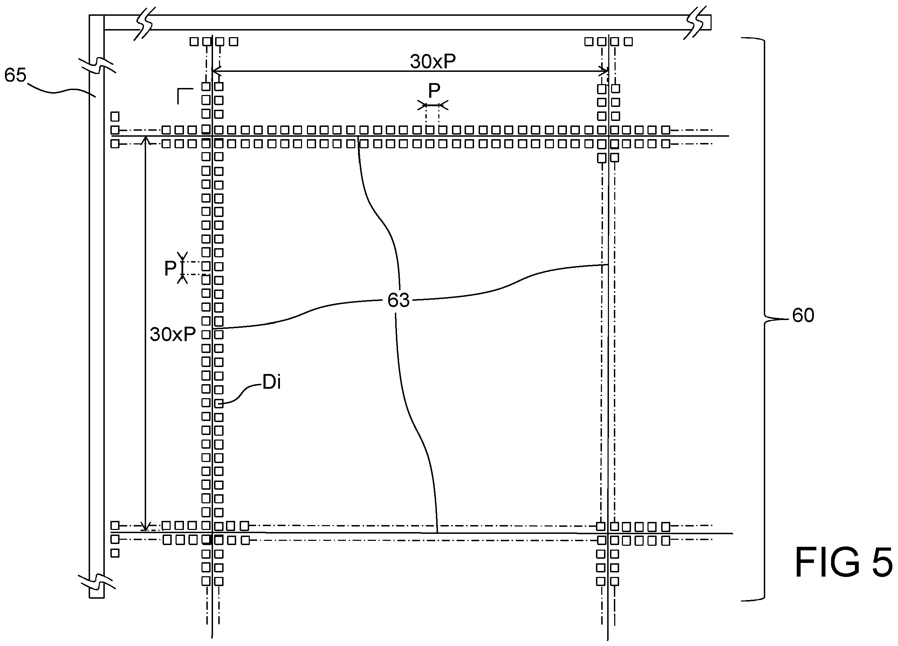

Selon un deuxième mode de réalisation de l'invention, décrit en figure 5, il y a dans une matrice 60, une ligne enterrée 63 entre deux lignes voisines et/ou entre deux colonnes voisines toutes les 30 lignes ou 30 colonnes de la matrice. La longueur d'une telle ligne conductrice enterrée 63 est de préférence supérieure ou égale à celle des lignes voisines et/ou celle des colonnes voisines. Il est bien sûr possible que cette longueur soit inférieure à celle à celle des lignes voisines et/ou celle des colonnes voisines. Lorsque cette longueur est strictement supérieure à celle des lignes voisines et/ou celle des colonnes voisines, l'interface entre toutes les diodes est bien stabilisée. Lorsque cette longueur est inférieure ou égale à celle des lignes voisines et/ou celle des colonnes voisines, l'interface des diodes de bord risque d'être non ou mal stabilisée.

La distance inter-contacts critique peut, en tenant compte d'une marge de sécurité, être estimée à une valeur proche de quinze fois une valeur du pas pixel P dans le cadre de la technologie pas pixel 15 µm.

Dans ce mode de réalisation de l'invention, chaque diode Di de la matrice 60 est au plus à une distance de 15 pas pixel d'une ligne conductrice enterrée 63. Ainsi, chaque diode est à une distance inter-contacts enterrée d'une ligne conductrice enterrée 63 inférieure à la distance inter-contacts critique.

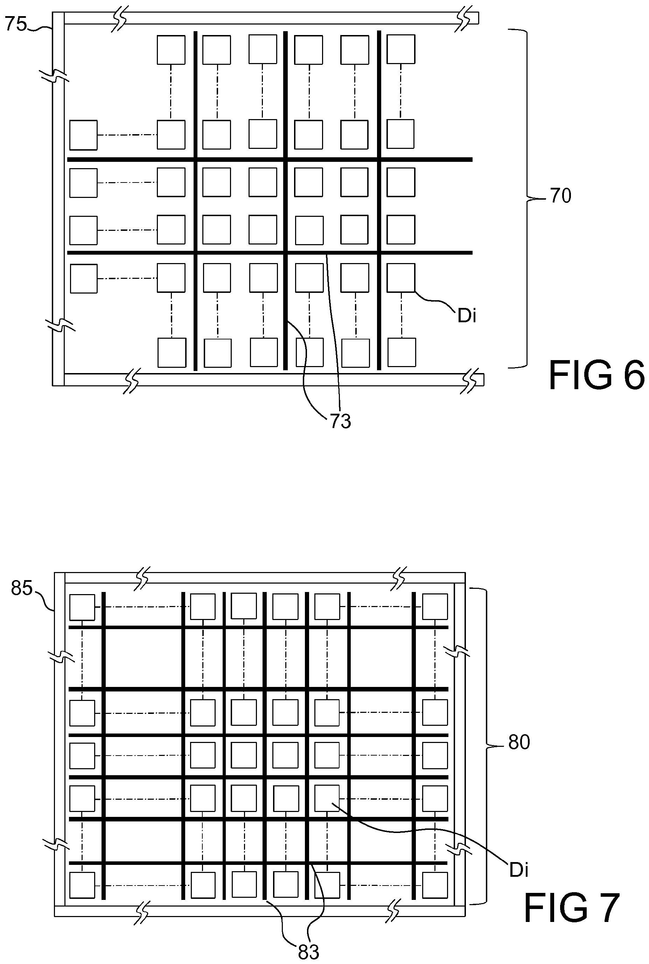

Selon un troisième mode de réalisation, illustré en figure 6, il y a dans la matrice 70 une ligne enterrée 73 s'étendant entre deux lignes voisines et/ou entre deux colonnes voisines toutes les deux lignes et/ou deux colonnes de la matrice. De plus, dans cette figure il a été représenté trois branches pour le contact substrat périphérique 75. Deux des branches de contact sont situées sur des côtés opposés de la matrice 70. Les lignes conductrices enterrées 73 ne sont reliées électriquement directement à aucune de ces branches de contact.

Une différence de potentiel appliquée entre les contacts diode des différentes diodes Di et un contact substrat périphérique 75 présent en bord de matrice devient assimilable à une différence de potentiel appliquée entre les contacts diode et les lignes conductrices enterrées 73 voisines.

Puisqu'on prévoit une ligne conductrice enterrée 73 entre deux lignes ou entre deux colonnes toutes les deux lignes et toutes les deux colonnes de la matrice, alors, les diodes Di sont encadrées quatre par quatre par des lignes conductrices enterrées 73. Chaque diode Di de la matrice perçoit donc un champ électrique sensiblement identique issu des lignes conductrices enterrées 73, variant uniquement par une rotation de 90°.

Dans un quatrième mode de réalisation, illustré en figure 7, il y a dans une matrice de diodes 80 une ligne conductrice enterrée 83 entre chaque ligne et entre chaque colonne de la matrice. Les valeurs de k et m sont alors respectivement égales à un.

De plus, dans cette figure il a été représenté quatre branches de contact pour le contact substrat périphérique 85. Les branches de contact sont situées en bordure de la matrice 80 et sont arrangées deux à deux de façon à border quatre côtés de la matrice, opposés deux à deux.

Dans l'invention, si les lignes conductrices enterrées n'ont pas une première conductivité au sens de l'invention, il sera préféré un agencement des lignes conductrices enterrées 73, 83 selon le troisième ou le quatrième mode de réalisation de l'invention, illustrés respectivement en figures 6 et 7. Dans ces deux modes de réalisation, chaque diode Di considérée est à proximité immédiate d'au moins une ligne conductrice enterrée 73, 83. C'est-à-dire qu'au moins une ligne conductrice enterrée s'étend entre ladite diode Di et au moins une diode voisine. En particulier, dans ces deux modes de réalisation, il est possible d'avoir deux lignes conductrices enterrées ou plus, situées à proximité immédiate de chaque diode.

Dans le cas du quatrième mode de réalisation, illustré en figure 7, chaque diode Di est à proximité immédiate de quatre lignes conductrices enterrées 83.

De plus, de façon indépendante de la densité en dopant utilisée dans les lignes conductrices enterrées, les troisième et quatrième modes de réalisation de l'invention permettent une stabilisation accrue de l'interface entre le substrat et la couche diélectrique superposée au substrat. Dans la suite de la description il sera utilisé les références de la figure 4B, appliquée à un cas où il y a plusieurs lignes conductrices enterrées 53.

Tel que présenté plus haut, la présence des zones dopées 52i des différentes diodes Di, proche de l'interface entre le substrat 51 et la couche diélectrique 59 superposée au substrat, forme des effets de charge importants au niveau de cette interface.

Lorsque les lignes conductrices enterrées 53 sont proches de cette interface et ont une densité de dopage importante, du même ordre de grandeur que la densité de dopage dans les zones dopées des diodes, ou d'un ordre de grandeur supérieur, on forme une barrière de potentiel au niveau de l'interface entre le substrat et la couche diélectrique 59. Ceci est le cas pour toute ligne conductrice enterrée 53 selon l'invention composée de matériau semi-conducteur dopé, dégénéré ou non. Il y a donc une diminution d'interactions entre des porteurs minoritaires et des états recombinant, ce qui est une cause de stabilisation de l'interface.

De plus, comme annoncé précédemment, les lignes conductrices enterrées 53 et la zone dopée 52i des diodes Di des dopages de type opposé. Alors, les lignes conductrices enterrées 53 induisent un équilibrage des charges au niveau de l'interface entre le substrat 51 et la couche diélectrique 59.

Ces deux points conduisent à une stabilisation de l'interface et un écrantage des effets de charge. Cela permet d'obtenir des bruits spatiaux, des bruits temporels et des bruits de cyclage réduits par rapport à une matrice selon l'état de la technique.

Dans le cas de lignes conductrices enterrées 53 à base de matériau semi-conducteur dopé avec un dopant de ligne, plus la largeur T et l'épaisseur H de la ligne conductrice enterrée 53 seront importantes, plus les effets d'écrantage et d'équilibrage des charges seront importants. En effet, le dopant de ligne a une présence au niveau de l'interface qui dépend des dimensions de la ligne conductrice enterrée 53 ainsi que du nombre de lignes conductrices enterrées 53 entourant chaque diode Di.

Dans un cas particulier de réalisation de l'invention, si le substrat est un matériau semi-conducteur à base de Hg₁₋ₓCdₓTe, dopé de type p, ayant un gap donné et une première composition x en cadmium, il est avantageux que les lignes conductrices enterrées 53 soient dopées p+ avec un dopant de ligne de type accepteur, par exemple de l'arsenic. En effet, si le dopant présent dans la ligne conductrice enterrée 53 est de type accepteur, il est possible de former facilement une hétérostructure autopositionnée de composition dans laquelle les lignes conductrices enterrées 53 ont une seconde composition en cadmium supérieure à la première composition en cadmium. La surface du substrat ou l'interface entre le substrat et la couche diélectrique 58 reste alors à la première composition en cadmium.

Le gap dans un matériau en Hg₁₋ₓCdₓTe dépend de la composition en cadmium. Ainsi, dans un dispositif tel que décrit ci-dessus, les lignes conductrices enterrées 53 sont dans un matériau ayant un plus grand gap que celui du substrat 51.

La formation dans les lignes conductrices enterrées 53 d'un gap plus important que celui du reste du substrat 51 permet de réduire les effets de charge en ajoutant une barrière de potentiel qui repousse les porteurs de l'interface.

Une matrice de diodes dont le substrat est en HgCdTe comporte généralement une couche de passivation, dont un des éléments est du cadmium Cd, située entre le substrat et la couche diélectrique.

Pour obtenir une hétérostructure auto-positionnée de composition, pour un substrat dopé p, il doit y avoir une couche de passivation dont un des éléments est du cadmium Cd, (non représentée), déposée sur le substrat, en contact avec toute zone dopée p+ où l'on désire augmenter la composition en cadmium. Il est ensuite procédé à une étape de diffusion comprenant en particulier un recuit, par exemple avec une température supérieure à 100°C pendant une durée supérieure à une minute. Il y a alors diffusion sélective de cadmium, depuis la couche de passivation, dans toute zone du substrat 51 en contact avec la couche de passivation et comportant un dopage p+. La concentration en cadmium et le gap sont ainsi localement augmentés dans ces zones. Si seules les lignes conductrices enterrées sont dopées avec un dopage de type p+, la diffusion sélective est limitée à un volume défini par les lignes conductrices enterrées 53.

De préférence, lorsqu'il est formé une hétérostructure de composition dans les lignes conductrices enterrées 53, celles-ci sont dopées p+ et les zones dopées 52i des diodes Di sont dopées n ou n+ de façon à ce que seules les lignes conductrices enterrées aient un gap plus élevé que celui du substrat 51.

Si, alternativement, on désire des diodes Di dopées p sans hétérostructure de composition et des lignes conductrices enterrées ayant une hétérostructure autopositionnée de composition, il est possible de former la couche de passivation en CdTe uniquement au niveau des lignes conductrices enterrées 53, en contact avec celles-ci avant de procéder au recuit précité. Dit autrement, une couche de passivation est déposée sur tout le substrat sauf à l'aplomb des diodes Di de façon à ne pas former d'hétérostructure autopositionnée de composition au niveau des diodes Di. Il sera ensuite nécessaire de passiver les diodes et le restant du substrat avec une couche de passivation dont un des éléments est du cadmium Cd. Dans ce cas, le contact diode peut typiquement être fabriqué après la formation des hétérostructures dans les lignes conductrices enterrées 53.

Cependant, si l'on désire former une hétérostructure de composition dans les zones dopées 52i des diodes, il est possible d'utiliser des zones dopées 52i ayant un dopage p ou p+. Dans la matrice les lignes conductrices enterrées 53i et le substrat ont le même type de dopage. Alors, il y a un plus faible équilibrage des charges à l'interface entre le substrat et la couche diélectrique.

Lorsqu'on utilise des lignes conductrices enterrées ayant une première conductivité au sens de l'invention, il est généralement plus avantageux d'avoir des lignes conductrices enterrées 53 en matériau semi-conducteur dégénéré plutôt qu'en métal. En effet, des lignes conductrices enterrées 53 métalliques ne peuvent conduire à une augmentation locale du gap, ni à la formation d'une barrière de potentiel par équilibrage des charges à l'interface entre le substrat 51 et la couche diélectrique 59.

Il peut même être considéré comme étant plus avantageux d'avoir des lignes conductrices enterrées à base d'un matériau semi-conducteur dopé non dégénéré en lieu et place d'un ou plusieurs métaux. En effet, avoir un gain G plus faible mais obtenir une réduction de bruit important grâce à une meilleure stabilisation de l'interface peut être plus avantageux qu'obtenir un gain G plus important sur la résistance parasite mais une stabilisation de l'interface plus faible si l'on emploie des lignes conductrices enterrées 53 en métal.

Le dopant de ligne peut avoir été introduit par une implantation ionique, à une profondeur proche d'un centre désiré de la section de la ligne conductrice enterrée 53, suivie d'un recuit permettant une diffusion du dopant. Un exemple particulier est l'implantation d'arsenic à 500 KeV à une dose d'implantation de 2.10¹⁵ at/cm² suivie par un recuit à 400°C pendant 5 heures.

De manière alternative, le dopant de ligne peut avoir été introduit par diffusion du dopant dans le matériau du substrat 51. Cela peut par exemple être obtenu en déposant un masque en résine sur le substrat 51. Puis le masque en résine subit une photolithographie de façon à présenter des ouvertures là où l'on désire former des lignes conductrices enterrées.

Le dopant est apporté en contact avec le substrat à travers les ouvertures présentes dans le masque en résine. Ensuite un recuit de diffusion est effectué de façon à faire diffuser le dopant dans le substrat 51 et former les lignes conductrices enterrées 53.

Le dopant peut être apporté sous forme gazeuse ou sous forme solide. Si le dopant est présenté sous forme solide il peut s'agir d'une couche de matériau déposée par-dessus le masque en résine et dans les ouvertures. Un tel matériau est retiré suite au recuit de diffusion.

## Revendications

1. Dispositif comportant un substrat (41.0, 51) en un matériau semi-conducteur à un ou plusieurs éléments chimiques, portant une matrice ( 50, 60, 70, 80) de diodes, organisées en lignes (L) et en colonnes (C), et un contact substrat périphérique (55) agencé sur au moins un côté de la matrice 50 60), le substrat (51) ayant un premier type de dopage et les diodes (Di) comportant dans le substrat (51), une deuxième zone dopée (52i) ayant un deuxième type de dopage, opposé au premier type, le substrat comportant plusieurs autres zones dopées, chacune formant une ligne conductrice enterrée (53, 63, 73, 83), enterrée dans le substrat, et les lignes conductrices enterrées (53, 63, 73, 83) :
- sont en un matériau semiconducteur composé du ou des mêmes éléments chimiques que le matériau semi-conducteur du substrat (51) ;
- affleurent une surface principale du substrat d'un côté où se trouvent les diodes (Di),
- n'atteignent aucune de branche(s) de contact du contact substrat périphérique (45.0, 55),
- sont positionnées entre les deuxièmes zones dopées (52i), et s'étendent entre deux colonnes voisines de diodes (Di) et entre deux lignes voisines de diodes (Di),
- sont séparées chacune de toute deuxième zone dopé (52i) des diodes (Di), au minimum par une distance minimale W" ;
- se croisent en une intersection et forment un maillage de lignes conductrices enterrées (53, 63, 73, 83), et ces lignes conductrices enterrées ont le premier type de dopage et une plus grande densité de dopage que dans le substrat, et un gap supérieur à celui du substrat.

2. Dispositif selon la revendication 1, dans lequel les lignes conductrices enterrées (53, 63, 73, 83) sont dopées avec un élément dopant, dit dopant de ligne présent avec une densité comprise entre 10¹⁵ et 10²⁰ at/cm³.

3. Dispositif selon la revendication 2, dans lequel les lignes conductrices enterrées (53, 63, 73, 83) sont en matériau semi-conducteur dégénéré.

4. Dispositif selon l'une des revendications 2 ou 3, dans lequel le substrat (51) est en un matériau à base de HgCdTe et le dopant de ligne est de l'arsenic ou du bore (53, 63, 73, 83).

5. Dispositif selon l'une des revendications 2 à 4, dans lequel, le substrat (51) est en un matériau à base de HgCdTe ayant, entre deux diodes voisines, une première composition en cadmium, et dans lequel les lignes conductrices enterrées (53, 63, 73, 83) ont un dopage de type « p » et ont une deuxième composition en cadmium plus élevée que la première composition.

6. Dispositif selon l'une des revendications 1 à 5, dans lequel ladite surface principale est une interface entre le substrat (51) et une couche diélectrique (59) recouvrant les diodes (Di) et le substrat (51).

7. Dispositif selon l'une des revendications 1 à 6, comportant une ligne conductrice enterrée (53, 63, 73, 83) entre deux colonnes voisines de diodes et/ou deux lignes voisines de diodes au moins toutes les k colonnes (C) et/ou les m lignes (L) de la matrice (50, 60, 70, 80), k et m valant trente, deux ou un.

8. Dispositif selon l'une des revendications 1 à 7, dans lequel chaque ligne conductrice enterrée (53, 63, 73, 83), présente entre deux lignes (L) voisines ou entre deux colonnes (C) voisines de longueurs données, a une longueur (λ) supérieure ou égale aux longueurs desdites colonnes (C) ou desdites lignes (L).

9. Dispositif selon l'une des revendications 1 à 8, dans lequel les lignes conductrices enterrées (53, 63, 73, 83) ont, définies dans un plan contenant les diodes, une longueur (λ) et une largeur (T), la largeur (T) étant perpendiculaire à la longueur (λ) et comprise entre 0,5 µm et 5 µm.

10. Dispositif selon l'une des revendications 1 à 9, dans lequel les lignes conductrices enterrées (53, 63, 73, 83) ont une épaisseur (H), définie suivant une normale à un plan contenant les diodes (Di), comprise entre 0,5 µm et 2 µm.

11. Dispositif selon l'une des revendications 1 à 10, dans lequel le substrat (41.0 ; 51) est en un matériau semi-conducteur à base de HgCdTe.

12. Dispositif selon l'une des revendications 1 à 11, dans lequel la distance minimale W" est d'au moins 0,5 µm.

13. Dispositif selon l'une des revendications 1 à 12, dans lequel chaque diode (Di) comporte un contact diode (54i) constitué d'un pied (57i) situé à l'intérieur de la zone dopée (52i) et d'une tête (58i) située en surface du substrat ( 51).

## Patentansprüche

1. Vorrichtung, die ein Substrat (41.0, 51) aus einem Halbleitermaterial mit einem oder mehreren chemischen Elementen, das eine Matrix (50, 60, 70, 80) aus in Zeilen (L) und in Spalten (C) organisierten Dioden trägt, und einen am Umfang liegenden Substratkontakt (55) umfasst, der auf mindestens einer Seite der Matrix (50, 60) angeordnet ist, wobei das Substrat (51) einen ersten Dotierungstyp aufweist, und wobei die Dioden (Di) im Substrat (51) eine zweite dotierte Zone (52i) mit einem dem ersten Typ entgegengesetzten zweiten Dotierungstyp umfassen, wobei das Substrat mehrere weitere dotierte Zonen umfasst, die jeweils eine vergrabene Leiterbahn (53, 63, 73, 83) bilden, die im Substrat vergraben ist, und wobei die vergrabenen Leiterbahnen (53, 63, 73, 83):
- aus einem Halbleitermaterial bestehen, das aus dem oder den gleichen chemischen Elementen wie das Halbleitermaterial des Substrats (51) zusammengesetzt ist;
- auf einer Seite, auf der sich die Dioden (Di) befinden, mit einer Hauptfläche des Substrats bündig sind,
- keine(n) Kontaktschenkel des am Umfang liegenden Substratkontakts (45.0, 55) erreichen,
- zwischen den zweiten dotierten Zonen (52i) positioniert sind und sich zwischen zwei benachbarten Dioden- (Di) Spalten und zwischen zwei benachbarten Dioden- (Di) Zeilen erstrecken,
- jeweils von jeder zweiten dotierten Zone (52i) der Dioden (Di) mindestens um einen minimalen Abstand W" getrennt sind;
- sich an einem Schnittpunkt kreuzen und eine Vernetzung der vergrabenen Leiterbahnen (53, 63, 73, 83) bilden,
und diese vergrabenen Leiterbahnen den ersten Dotierungstyp und eine höhere Dotierungsdichte als im Substrat, und einen größeren Spalt als den des Substrats aufweisen.

2. Vorrichtung nach Anspruch 1, wobei die vergrabenen Leiterbahnen (53, 63, 73, 83) mit einem als Bahndotierung bezeichneten Dotierungselement dotiert sind, das in einer Dichte im Bereich zwischen 10¹⁵ und 10²⁰ at/cm³ vorliegt.

3. Vorrichtung nach Anspruch 2, wobei die vergrabenen Leiterbahnen (53, 63, 73, 83) aus degeneriertem Halbleitermaterial bestehen.

4. Vorrichtung nach einem der Ansprüche 2 oder 3, wobei das Substrat (51) aus einem Material auf Basis von HgCdTe besteht, und es sich bei der Bahndotierung um Arsen oder Bor (53, 63, 73, 83) handelt.

5. Vorrichtung nach einem der Ansprüche 2 bis 4, wobei das Substrat (51) aus einem Material auf Basis von HgCdTe besteht, das zwischen zwei benachbarten Dioden eine erste Cadmiumzusammensetzung aufweist, und wobei die vergrabenen Leiterbahnen (53, 63, 73, 83) eine Dotierung vom "p"-Typ aufweisen und eine zweite, höhere Cadmiumzusammensetzung als die erste Zusammensetzung aufweisen.

6. Vorrichtung nach einem der Ansprüche 1 bis 5, wobei es sich bei der Hauptfläche um eine Grenzfläche zwischen dem Substrat (51) und einer dielektrischen Schicht (59), welche die Dioden (Di) und das Substrat (51) bedeckt, handelt.

7. Vorrichtung nach einem der Ansprüche 1 bis 6, die mindestens alle k Spalten (C) und/oder m Zeilen (L) der Matrix (50, 60, 70, 80) eine vergrabene Leiterbahn (53, 63, 73, 83) zwischen zwei benachbarten Diodenspalten und/oder zwei benachbarten Diodenzeilen umfasst, wobei k und m den Wert dreißig, zwei oder eins besitzen.

8. Vorrichtung nach einem der Ansprüche 1 bis 7, wobei jede vergrabene Leiterbahn (53, 63, 73, 83) zwischen zwei benachbarten Zeilen (L) bzw. zwischen zwei benachbarten Spalten (C) gegebener Längen eine Länge (λ) aufweist, die größer oder gleich den Längen der Spalten (C) bzw. der Zeilen (L) ist.

9. Vorrichtung nach einem der Ansprüche 1 bis 8, wobei die vergrabenen Leiterbahnen (53, 63, 73, 83) in einer die Dioden enthaltenden Ebene definiert, eine Länge (λ) und eine Breite (T) aufweisen, wobei die Breite (T) senkrecht zur Länge (λ) verläuft und im Bereich zwischen 0,5 µm und 5 µm liegt.

10. Vorrichtung nach einem der Ansprüche 1 bis 9, wobei die vergrabenen Leiterbahnen (53, 63, 73, 83) eine Dicke (H), entlang einer Normalen zu einer die Dioden (Di) enthaltenden Ebene definiert, um Bereich zwischen 0,5 µm und 2 µm aufweisen.

11. Vorrichtung nach einem der Ansprüche 1 bis 10, wobei das Substrat (41.0; 51) aus einem Halbleitermaterial auf Basis von HgCdTe besteht.

12. Vorrichtung nach einem der Ansprüche 1 bis 11, wobei der minimale Abstand W" mindestens 0,5 µm beträgt.

13. Vorrichtung nach einem der Ansprüche 1 bis 12, wobei jede Diode (Di) einen Diodenkontakt (54i) umfasst, der aus einem im Inneren der dotierten Zone (52i) liegenden Fuß (57i) und einem an der Oberfläche des Substrats (51) liegenden Kopf (58i) besteht.

## Claims

1. Device comprising a substrate (41.0, 51) made of a semi-conductor material of one or plural chemical elements supporting a matrix (50, 60, 70, 80) of diodes organised in rows (L) and columns (C), and a peripheral substrate contact (55) arranged on at least one side of the matrix (50 60), the substrate (51) having a first type of doping and the diodes (Di) comprising a second doped zone (52i) in the substrate (51), having a second type of doping opposite the first type,
the substrate comprising several other doped zones, and each forming a buried conducting line (53, 63, 73, 83) buried in the substrate, the buried conducting lines are :
- made of a semi-conductor material composed of the or the same chemical elements than said semi-conductor material of said substrate;
- are flush with a principal surface of the substrate (51) on the side on which the diodes are present (Di),
- have no direct electrical connection with the peripheral substrate contact, are positioned between the second doped zones (52i),
- extend between two adjacent columns of diodes (Di) and two adjacent rows of diodes (Di),
- intersect at an intersection and form a mesh of buried conducting lines (53, 63, 73, 83), and these buried conducting lines having the first type of doping and a greater doping density than the substrate and a gap greater than the gap of the substrate.

2. Device according to claim 1, wherein the buried conducting lines (53, 63, 73, 83) are composed of the same chemical element(s) as the semiconducting material of the substrate (51) and are doped with a doping element called the line dopant present with a density between 10¹⁵ and 10²⁰ at/cm³.

3. Device according to claim 2, wherein the buried conducting lines (53, 63, 73, 83) are made of a degenerated semiconducting material.

4. Device according to either claim 2 or 3, wherein the substrate (51) is made of an HgCdTe-based material and the line dopant is arsenic or boron (53, 63, 73, 83).

5. Device according to one of claims 2 to 4, wherein the substrate (51) is an HgCdTe-based material having a first cadmium composition between two adjacent diodes, and in which the buried conducting lines (53, 63, 73, 83) have a « p » type doping and have a second cadmium composition higher than the first composition.

6. Device according to one of claims 1 to 5, wherein the principal surface is an interface between the substrate (51) and a dielectric layer (59) covering the diodes (Di) and the substrate (51).

7. Device according to one of claims 1 to 6, comprising a buried conducting line (53, 63, 73, 83) between two adjacent columns of diodes or two adjacent rows of diodes at least every k columns (C) and/or m rows (L) of the matrix (50, 60, 70, 80), k and m being equal to thirty, two or one.

8. Device according to one of claims 1 to 7, wherein each buried conducting line (53, 63, 73, 83) present between two adjacent rows (L) or between two adjacent columns (C) with given lengths, is the same length (λ) as or is longer than the length of said columns (C) or said rows (L).

9. Device according to one of claims 1 to 8, wherein the buried conducting lines (53, 63, 73, 83) have a length (λ) and a width (T) defined in a plane containing the diodes, the width (T) being perpendicular to the length (λ) and being between 0.5 µm and 5 µm.

10. Device according to one of claims 1 to 9, wherein the thickness (H) of the buried conducting lines (53, 63, 73, 83) defined approximately along a normal to a plane containing the diodes (Di), is between about 0.5 µm and 2 µm.

11. Device according to any of the claims 1 to 10, wherein the substrate (41.0; 51) is made of an HgCdTe-based material.

12. Device according to any of the claims 1 to 11, wherein the minimum width W" is at least 0.5 µm.

13. Device according to any of the claims 1 to 12, wherein each diode (Di) comprises a diode contact (54i) formed of a foot (51i) inside said doped region (52i) and a head (58i) located at the substrate's surface (51).
